# EUROPEAN PATENT APPLICATION

(11) **EP 4 756 461 A1**
(43) Date of publication of application: **10.06.2026**
(21) Application number: 25208692.1
(22) Date of filing: 14.10.2025
(51) Int. Cl.: G01R 31/396

(54) **APPARATUS AND METHOD FOR DETECTING ABNORMAL CELL OF BATTERY MODULE**

(30) Priority: 09.12.2024 KR 20240181983
(71) Applicant: SAMSUNG SDI CO., LTD., Yongin-si, Gyeonggi-do 17084 (KR)
(72) Inventor: SEO, Jeawon, Yongin-si 17084 (KR)
(74) Representative: Marks & Clerk LLP

(57) **Abstract**

An apparatus for detecting abnormal cell of battery module includes a charging current detector configured to detect whether a charging current reaches a first criterion during charging of a battery module comprising a plurality of battery cells, a state of charge (SOC) detector configured to detect whether an SOC reaches a second criterion, a cell voltage measurement part configured to measure a voltage of each cell, and a cell abnormality determination part configured to store the measured voltage of each cell as a maximum voltage, then compare a current voltage with the stored maximum voltage when the current voltage that is less than or equal to the maximum voltage is measured, and when a difference between the stored maximum voltage and the current voltage is greater than or equal to an allowable value, determine that a corresponding cell is an abnormal cell.

## Description

### BACKGROUND

### 1. Field

The present disclosure relates to an apparatus and method for detecting an abnormal battery cell in a battery module mounted in an energy storage system.

### 2. Description of the Related Art

While primary batteries are not designed to be recharged, secondary batteries can be discharged and recharged. Low-capacity secondary batteries are used in small portable electronic devices, such as smart phones, feature phones, notebook computers, digital cameras, and camcorders. Large-capacity secondary batteries are widely used as power sources for driving motors, such as in hybrid vehicles or electric vehicles, and for power storage. A secondary battery may include an electrode assembly comprising a positive electrode and a negative electrode, a case for accommodating the electrode assembly, and electrode terminals connected to the electrode assembly.

When a lithium-ion battery is charged, lithium ions move from a positive electrode to a negative electrode. But side reactions with an electrolyte may cause abnormalities in cells. When such side reactions occur, performance of the battery may be degraded and the probability of fire increases. One of phenomena resulting from side reactions is an abnormal voltage drop phenomenon in an upper section of a state of charge (SOC).

The information disclosed in this section is for enhancement of understanding of the background of the present disclosure. It may contain information that does not constitute a related or prior art.

### SUMMARY OF THE DISCLOSURE

The present disclosure is directed to preparing for performance degradation and preventing a fire by estimating a side reaction during charging of a battery pack, an energy storage system (ESS), an electric vehicle, etc., and determining whether a battery cell is abnormal.

According to an aspect of the present disclosure, there is provided an apparatus for detecting an abnormal cell of a battery module, which includes a charging current detector configured to detect whether a charging current reaches a first criterion during charging of a battery module comprising a plurality of battery cells, a state of charge (SOC) detector configured to detect whether an SOC of the battery module reaches a second criterion, a cell voltage measurement part configured to measure a voltage of each of the battery cells when the charging current reaches the first criterion and the SOC reaches the second criterion, and a cell abnormality determination part configured to (i) store the measured voltage of each of the battery cells as a maximum voltage, (ii) compare a current voltage with the stored maximum voltage when the current voltage that is less than or equal to the maximum voltage, and (iii) determine that a corresponding battery cell of the battery cells is an abnormal cell when a difference between the stored maximum voltage and the current voltage is greater than or equal to an allowable value.

According to another aspect of the present disclosure, there is provided a method of detecting an abnormal cell of a battery module, which includes detecting whether a charging current reaches a first criterion during charging of a battery module comprising a plurality of battery cells, detecting whether an SOC of the battery module reaches a second criterion, measuring a voltage of each cell when a charging current reaches the first criterion and the SOC reaches the second criterion, and a cell abnormality determination operation of (i) storing the measured voltage of each of the battery cells as a maximum voltage, (ii) comparing a current voltage with the stored maximum voltage when the current voltage that is less than or equal to the maximum voltage is measured, and (iii) determining that a corresponding battery cell of the battery cells is an abnormal cell when a difference between the stored maximum voltage and the current voltage is greater than or equal to an allowable value.

According to still another aspect of the present disclosure, there is provided a method of detecting an abnormal cell of a battery module, which includes detecting whether a charging current reaches a C-rate during charging of a battery module comprising a plurality of battery cells, detecting whether a state of charge (SOC) reaches 80% to 90%, measuring a voltage of each of the battery cells when the charging current reaches the C-rate and the SOC reaches 80% to 90%, storing the measured voltage of each of the battery cells as a maximum voltage, comparing the stored maximum voltage with a current voltage measured after the maximum voltage is stored, calculating a difference between the stored maximum voltage and the current voltage when the current voltage is less than or equal to the maximum voltage, and, determining that a corresponding battery cell of the battery cells is an abnormal cell when the difference between the stored maximum voltage and the current voltage is 10 mV or more.

Aspects and features of the present disclosure are not limited to those described above, and other aspects and features not specifically mentioned herein will be clearly understood by those skilled in the art from the description of the present disclosure below.

At least some of the above and other features of the invention are set out in the claims.

### BRIEF DESCRIPTION OF THE DRAWINGS

The drawings illustrate embodiments of the present disclosure and further describe aspects and features of the present disclosure together with the detailed description of the present disclosure. The present disclosure is not limited to the embodiments depicted in the drawings.
FIG. 1 is illustrates a pouch-type secondary battery;
FIG. 2 is a cross-sectional view of a cylindrical secondary battery;
FIG. 3A is a top perspective view of an exterior of a prismatic secondary battery;
FIG. 3B is a cross-sectional view along I-I' of FIG. 3A;
FIG. 4 is illustrates a secondary battery module in which secondary batteries are disposed;
FIG. 5 illustrates a secondary battery pack formed using the secondary battery module shown in FIG. 4 to an actual product;
FIG. 6 is a diagram of a vehicle including the secondary battery pack shown in FIG. 5;
FIG. 7 is a diagram illustrating an abnormal voltage drop phenomenon occurs due to a side reaction occurring in an upper section of a state of charge (SOC) during battery charging;
FIG. 8 is a block diagram of an apparatus for detecting an abnormal cell by a side reaction detection according to embodiments of the present disclosure;
FIG. 9 is a diagram illustrating some embodiments of a battery management system (BMS) including an analog front end (AFE);
FIG. 10 is a diagram illustrating an embodiment in which the BMS is formed separately as a module BMS and a rack BMS;
FIG. 11 is a diagram illustrating a shunt resistor for detecting a charging current of a charging current detector; and
FIG. 12 is a process flowchart of a method of detecting an abnormal cell using a cell abnormality determination part of an apparatus for detecting an abnormal cell according to some embodiments of the present disclosure.

### DETAILED DESCRIPTION OF EXAMPLE EMBODIMENTS

Hereinafter, embodiments of the present disclosure will be described, in detail, with reference to the accompanying drawings. The terms or words used in the present specification and claims are not to be narrowly interpreted according to their general or dictionary meanings and should be interpreted as having meanings and concepts that are consistent with the technical idea of the present disclosure on the basis of the principle that an inventor can be his/her own lexicographer to appropriately define concepts of terms to describe his/her invention in the best way. The embodiments described in this specification and the configurations shown in the drawings are only some embodiments of the present disclosure and do not represent all of the aspects, features, and embodiments of the present disclosure. Accordingly, it should be understood that there may be various equivalents and modifications that can replace or modify one or more embodiments or features therein described herein at the time of filing this application.

It will be further understood that the terms "includes," "including," "comprises," and/or "comprising," if used in this specification, specify the presence of stated features, integers, steps, operations, elements, and/or components but do not preclude the presence or addition of one or more other features, integers, steps, operations, elements, components, and/or groups thereof.

In the figures, dimensions of the various elements, layers, etc. may be exaggerated for clarity of illustration. In addition, the same reference numerals may be assigned to the same components in different embodiments.

References to two compared elements, features, etc. as being "the same" may mean that they are "substantially the same." Thus, the phrase "substantially the same" may include a case having a deviation that is considered low in the art, for example, a deviation of 5% or less. In addition, if a certain parameter is referred to as being uniform in a given region, it may mean that it is uniform in terms of an average.

It will be understood that although the terms first, second, third, etc. may be used herein to describe various elements, components, regions, layers, and/or sections, these elements, components, regions, layers, and/or sections should not be limited by these terms. These terms are only used for distinguishing one component from another component, and unless otherwise stated, a first component may also be a second component.

Throughout the specification, unless otherwise stated, each element may be singular or plural.

Arranging an arbitrary element "above (or below)" or "on (under)" another element may mean that the arbitrary element may contact the upper (or lower) surface of the element, and another element may also be interposed between the element and the arbitrary element located on (or under) the element.

In addition, it will be understood that if a component is referred to as being "linked," "coupled," or "connected" to another component, the elements may be directly "coupled," "linked" or "connected" to each other, or another component may be "interposed" between the components."

As used herein, the term "and/or" includes any and all combinations of one or more of the associated listed items. Further, the use of "may" if describing embodiments of the present disclosure relates to "one or more embodiments of the present disclosure." Expressions, such as "at least one of" and "any one of," if preceding a list of elements, modify the entire list of elements and do not modify the individual elements of the list.

Throughout the specification, if "A and/or B" is stated, it means A, B or A and B, unless otherwise stated and if "C to D" is stated, it means C or more and D or less, unless otherwise stated.

When phrases such as "at least one of A, B and C, "at least one of A, B or C," "at least one selected from a group of A, B and C," or "at least one selected from among A, B and C" are used to designate a list of elements A, B and C, the phrase may refer to any and all suitable combinations or a subset of A, B and C, such as A, B, C, A and B, A and C, B and C, or A and B and C.

As used herein, the terms "use," "using," and "used" may be considered synonymous with the terms "utilize," "utilizing," and "utilized," respectively. As used herein, the terms "substantially," "about," and similar terms are used as terms of approximation and not as terms of degree, and are intended to account for the inherent variations in measured or calculated values that would be recognized by those of ordinary skill in the art.

It will be understood that, although the terms first, second, third, etc. may be used herein to describe various elements, components, regions, layers, and/or sections, these elements, components, regions, layers, and/or sections should not be limited by these terms. These terms are used to distinguish one element, component, region, layer, or section from another element, component, region, layer, or section. Thus, a first element, component, region, layer, or section discussed below could be termed a second element, component, region, layer, or section without departing from the teachings of example embodiments.

Spatially relative terms, such as "beneath," "below," "lower," "above," "upper," and the like, may be used herein for ease of description to describe one element or feature's relationship to another element(s) or feature(s) as illustrated in the figures. It will be understood that the spatially relative terms are intended to encompass different orientations of the device in use or operation in addition to the orientation depicted in the figures. For example, if the device in the figures is turned over, elements described as "below" or "beneath" other elements or features would then be oriented "above" or "over" the other elements or features. Thus, the term "below" may encompass both an orientation of above and below.

The terminology used herein is for the purpose of describing embodiments of the present disclosure and is not intended to limit the present disclosure.

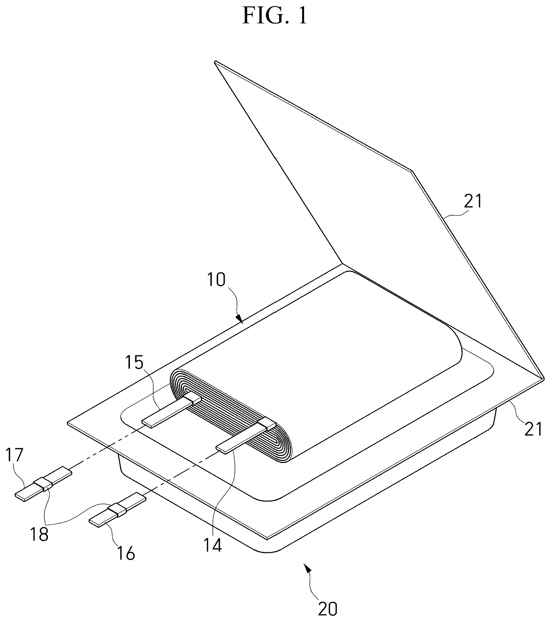

FIG. 1 illustrates a pouch-type secondary battery. The pouch-type secondary battery includes an electrode assembly 10 and a pouch 20 that accommodates the electrode assembly 10. A first electrode tab 14 and a second electrode tab 15 of the electrode assembly 10 may be electrically connected to respective external first and second terminal leads 16 and 17 by welding. A tab film 18 may be attached to each of the first terminal lead 16 and the second terminal lead 17 for insulation from the pouch. 20.

The pouch 20 may be sealed by having sealing parts 21 at the edges contact each other with the electrode assembly 10 accommodated in the pouch 20. The sealing may be achieved with the tab film 18 interposed between the sealing parts 21. The sealing parts 21 of the pouch 20 may each be made of a thermal fusion material that generally has weak adhesion to metal. Thus, the pouch 20 may be fused by interposing the thin tab film 18 between the sealing parts 21.

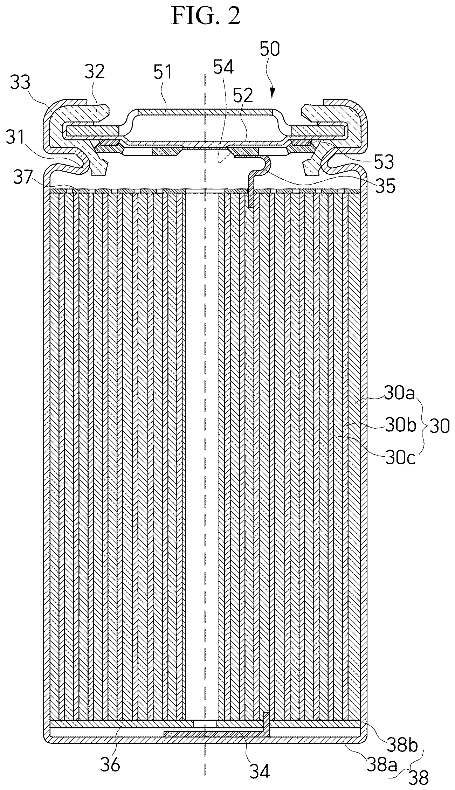

FIG. 2 illustrates a cylindrical secondary battery. As shown in FIG. 2 the secondary battery includes an electrode assembly 30, a case 38 accommodating the electrode assembly 30 and an electrolyte therein, a cap assembly 50 coupled to an opening of the case 38 to seal the case 38, and an insulating plate 37 positioned between the electrode assembly 30 and the cap assembly 50 inside the case.

The electrode assembly 30 may include a first electrode 30c and a second electrode 30a positioned with a separator 30b interposed between the electrodes 30c and 30a. The electrode assembly 30 may be wound in a jelly-roll shape.

The first electrode 30c includes a first substrate and a first active material layer on the first substrate. A first lead tab 35 may extend outwardly from a first uncoated portion of the first substrate where the first active material layer is not provided, and the first lead tab 35 may be electrically connected to the cap assembly 50.

The second electrode 30a includes a second substrate and a second active material layer on the second substrate. A second lead tab 34 may extend outwardly from a second uncoated portion of the second substrate at where the second active material layer is not provided, and the second lead tab 34 may be electrically connected to the case 38. The first lead tab 35 and the second lead tab 34 may extend in opposite directions.

The first electrode 30c may function as a positive electrode. In such an embodiment, the first substrate may be made of, for example, an aluminum foil, and the first active material layer may include, for example, a transition metal oxide. The second electrode 30a may act as a negative electrode. In such an embodiment, the second substrate may be made of, for example, a copper foil or a nickel foil, and the second active material layer may include, for example, graphite.

The separator 30b prevents a short circuit between the first electrode and the second electrode while allowing movement of lithium ions therebetween. The separator 30b may be made of, for example, a polyethylene film, a polypropylene film, a polyethylene-polypropylene film, or the like.

The case 38 accommodates the electrode assembly 30 and, together with the cap assembly 50, forms the external appearance of the secondary battery. The case 38 may have a substantially cylindrical body portion 38b and a bottom portion 38a connected to one side (e.g., to one end) of the body portion 38b. A beading part 31 (e.g., a bead) deformed inwardly may be formed in the body portion 38b. A crimping part 33 (e.g., a crimp) may be bent inwardly at an open end of the body portion 38b.

The beading part 31 can reduce or prevent movement of the electrode assembly 30 inside the case 38 and can facilitate seating of the gasket 32 and the cap assembly 50. The crimping part 33 may firmly fix the cap assembly 50 by pressing the edge of the case 38 against the gasket 32. The case 38 may be formed of, for example, iron plated with nickel.

The cap assembly 50 may be fixed to the inside of the crimping part 33 by a gasket 32 to seal the case 38. The cap assembly 50 may include an upper cap 51, a safety vent 52, a lower cap 53, an insulating member, and a sub plate 54. But the cap assembly 50 is not limited to such a configuration and may be modified in various ways.

The upper cap 51 may be positioned at the uppermost part of the cap assembly 50. The upper cap 51 may include a terminal part that protrudes upwardly and is connected to an external circuit. An outlet for discharging gas may be arranged around the terminal part.

The safety vent 52 may be located under the upper cap up 51. The safety vent 52 may include a protrusion part that protrudes convexly downward and is connected to the sub plate 54. At least one notch may be formed in the safety vent around the protrusion part.

When gas is generated due, for example, to overcharging or abnormal operation of the secondary battery, the protrusion part is deformed upwardly by the gas pressure and separates from the sub plate 54 while the safety vent 52 is cut (e.g., bursts or tears) along the notch. The cut safety vent 52 may prevent the secondary battery from exploding by allowing for the gas to be discharged to outside of the battery.

The lower cap 53 may be positioned below the safety vent 52. A first opening may be formed in the lower cap 53 for exposing the protrusion part of the safety vent 52 and a second opening may be formed in the lower cap 53 for gas discharge. The insulating member may be positioned between the safety vent 52 and the lower cap 53 to insulate the safety vent 52 and the lower cap 53.

The sub plate 54 may be positioned under the lower cap 53 and fixed to a lower surface of the lower cap 53 to block the first opening of the lower cap 53. The protrusion part of the safety vent 53 may be fixed to the sub plate 54. The first lead tab 35, which extends from the electrode assembly 30, may be fixed to the sub plate 54. With such a configuration, the upper cap 51, the safety vent 52, the lower cap 53, and the sub plate 54 may be electrically connected to the first electrode 30c of the electrode assembly 30.

The insulating plate 37 may be positioned to be in contact with the electrode assembly 30 below the beading part 13. The insulating plate 37 may have a tab opening through which the first lead tab 35 extends. The cap assembly 50, which is electrically connected to the first electrode by the first lead tab, may face the electrode assembly with an insulating plate 37 interposed between the cap assembly 50 and the electrode assembly to insulate (e.g., electrically insulated) the cap assembly 50 from the electrode assembly 30. Another insulating plate 36 may be included for insulation between the electrode assembly 30 and the bottom portion 38a of the case 38.

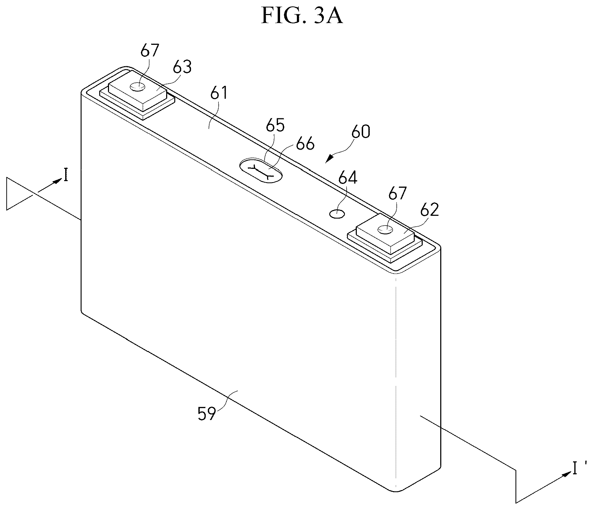

FIG. 3A is a top perspective view of a prismatic secondary battery according to embodiments of the present disclosure.

A case 59 defines an outer appearance of the prismatic secondary battery may be made of a conductive metal, such as aluminum, aluminum alloy, or nickel-plated steel. The case 59 provides a space for accommodating an electrode assembly therein.

A cap assembly 60 may include a cap plate 61 that covers the opening of the case 51. In some examples, the case 59 and the cap plate 61 may be made of a conductive material. A first terminal 63 and a second terminal 62 may be electrically connected to respective positive and negative (or negative and positive) electrodes inside the case. The first and second terminals 63 and 62 may protrude outward through the cap plate 61.

The cap plate 61 may include an electrolyte injection port 64 and a sealing plug (or seal pin). A vent 66 corresponding to a gas discharge hole 65 is provided for discharging gas generated inside the secondary battery.

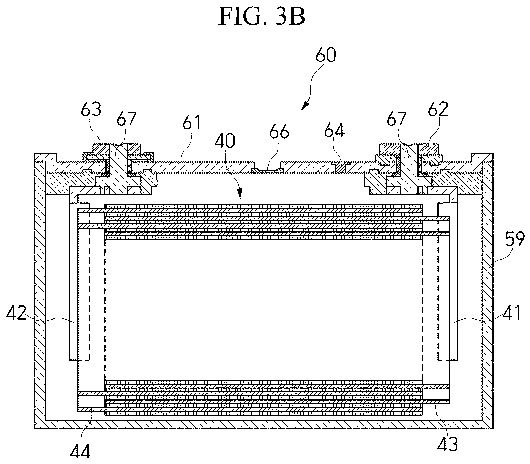

FIG. 3B is a cross-sectional view taken along the line I-I' of FIG. 3A, according to embodiments of the present disclosure.

A prismatic secondary battery may include an electrode assembly 40, a first current collector 41, a first terminal 62, a second current collector 42, a second terminal 63, and a cap assembly 60.

An electrode assembly 40 may be formed by winding or stacking a first electrode plate, a separator, and a second electrode plate, which are formed as thin plates or films. When the electrode assembly 40 is a wound stack, a winding axis may be parallel to the longitudinal direction (e.g., the y direction) of the case 51. In other embodiments, the electrode assembly 40 is a stack type rather than a winding type. But the shape of the electrode assembly 40 is not limited in the present disclosure. As a further example, the electrode assembly 40 may be a Z-stack electrode assembly in which a positive electrode plate and a negative electrode plate are inserted to both sides of a separator, which is then bent into a Z-stack. One or more electrode assemblies may be stacked such that long sides of the electrode assemblies are adjacent to each other and accommodated in the case. The number of electrode assemblies in the case is not limited in the present disclosure. The first electrode plate of the electrode assembly may act as a negative electrode, and the second electrode plate may act as a positive electrode. Of course, the reverse is also possible.

The first electrode plate may be formed by applying a first electrode active material, such as graphite, carbon, or the like, to a first electrode current collector formed of a metal foil, such as copper, a copper alloy, nickel, a nickel alloy, or the like. The first electrode plate may include a first electrode tab 43 (e.g., a first uncoated portion), which is a region to which the first electrode active material is not provided. The first electrode tab 43 form a current flow path between the first electrode plate and the first current collector 41. In some embodiments, when the first electrode plate is made, the first electrode tab 43 is formed by being cut to protrude to one side of the electrode assembly 40. In other embodiments, the first electrode tab 43 protrudes to one side of the electrode assembly 40 more than (e.g., farther than or beyond) the separator without being separately cut.

The second electrode plate may be formed by applying a second electrode active material, such as a transition metal oxide, on a second electrode current collector formed of a metal foil, such as aluminum or an aluminum alloy. The second electrode plate may include a second electrode tab 44 (e.g., a second uncoated portion) that is a region to which the second electrode active material is not provided. The second electrode tab 44 may form a current flow path between the second electrode plate and the second current collector 42. In some embodiments, the second electrode tab 44 may be formed by being cut to protrude to the other side (e.g., the opposite side) of the electrode assembly when the second electrode plate is made. In other embodiments, the second electrode plate may protrude to the other side of the electrode assembly more than (e.g., farther than or beyond) the separator without being separately cut.

The separator prevents or substantially reduces instances of short circuits between the first electrode and the second electrode while allowing movement of lithium ions between the electrodes. The separator may be made of, for example, a polyethylene film, a polypropylene film, a polyethylene-polypropylene film, or the like.

In some embodiments, the electrode assembly 40 is accommodated in the case 10 along with an electrolyte. In the electrode assembly 40, the first current collector 41 and the second current collector 42 may be welded and connected to the first electrode tab 43 extending from the first electrode plate and the second electrode tab 44 extending from the second electrode plate, respectively. In embodiments in which the first electrode tab 43 and the second electrode tab 44 are located at the top of the electrode assembly 40, the first and second current collectors are located at the top of the electrode assembly 40.

The first current collector 41 and the second current collector 42 are connected to the first terminal 62 and the second terminal 63 by connection members 67, respectively. The connection members 67 may each have an outer peripheral surface that is threaded. As such, the connection members 67 may be fastened to the first terminal 62 and the second terminal 63 by screwing. However, the present disclosure is not limited to such a configuration. For example, the connection members 67 may also be coupled to the first terminal 62 and the second terminal 63 by riveting or welding.

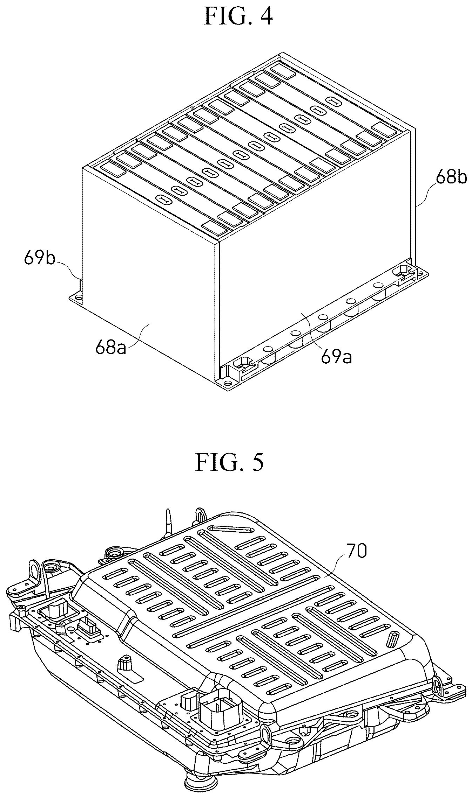

FIG. 4 is a perspective view of a secondary battery module in which secondary batteries are arranged according to embodiments of the present disclosure. To fulfill the increased need for secondary battery capacity for applications such as driving electric vehicles or the like, a secondary battery module may be made by arranging a plurality of secondary battery cells transversely and/or longitudinally and connecting them together. The plurality of secondary batteries may be arranged in a space defined by a pair of facing end plates 68a and 68b and a pair of facing side plates 69a and 69b. The secondary batteries may be arranged in a direction and number to obtain desired voltage and current specifications.

FIG. 5 is a perspective view of a battery pack 70 according to embodiments of the present disclosure. The battery pack 70 may include an assembly to which individual batteries are electrically connected and a pack housing accommodating the assembly. In the drawings, components including a bus bar, a cooling unit, external terminals for electrically connecting batteries, etc., are not shown.

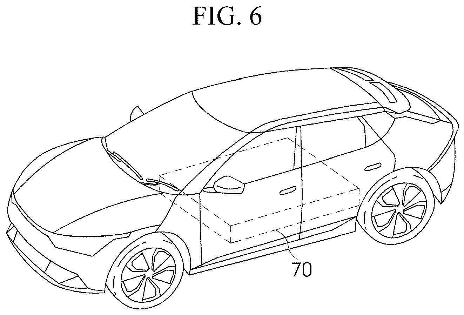

The battery pack 70 may be mounted on or in a vehicle. The vehicle may be, for example, an electric vehicle, a hybrid vehicle, or a plug-in hybrid vehicle. The vehicle may be a four-wheeled vehicle or a two-wheeled vehicle, but is not limited thereto. FIG. 6 shows a vehicle that includes the battery pack 70 shown in FIG. 5 on the lower body thereof. The vehicle V may operate by (e.g., powered by) receiving power from the battery pack 70.

A secondary battery pack may include a battery and a battery management system (BMS) for managing the battery. The BMS measures and determines the voltage (V), current (I), temperature (T), etc. of a battery installed in an electric vehicle or ESS through sensors, and the BMS controls the battery so that it can perform optimally.

The battery management system may include a detection device, a balancing device, and a control device. The battery module may include a plurality of cells connected to each other in series and/or parallel. The battery modules may be connected to each other in series and/or in parallel.

The detection device may detect a state of a battery (e.g., voltage, current, temperature, etc.) and output state information indicating the state of the battery. The detection device may detect the voltage of each cell constituting the battery and/or of each battery module. The detection device may detect current flowing through each battery module constituting the battery module or the battery pack. The detection device may also detect the temperature of a cell and/or module in at least one point of the battery and/or an ambient temperature.

The balancing device may perform a balancing operation of a battery module and/or cells constituting the battery module. The control device may receive state information (e.g., voltage, current, temperature, etc.) of the battery module from the detection device. The control device may monitor and calculate the state of the battery module (e.g., voltage, current, temperature, state of charge (SOC), life span (state of health (SOH)), etc.) based on the state information received from the detection device. In addition, based on the monitored state information, the control device may perform a control function (e.g., temperature control, balancing control, charge/discharge control, etc.) and a protection function (e.g., over-discharge, overcharge, over-current protection, short circuit, fire extinguishing function, etc.). In addition, the control device may perform a wired or wireless communication function with an external device of the battery pack (e.g., a higher level controller or vehicle, charger, power conversion system, etc.).

The control device may control charging/discharging operation and protection operation of the battery. As such, the control device may include a charge/discharge control unit, a balancing control unit, and/or a protection unit.

The battery management system monitors the battery state and performs diagnosis and control, communication, and protection functions. The battery management system also may calculate the charge/discharge state, calculate battery life or state of health (SOH), cut off battery power (e.g., relay control), control thermal management (e.g., cooling, heating, etc.), perform a high-voltage interlock function, and/or may detect and/or calculate insulation and short circuit conditions.

A relay may be a mechanical contactor that is turned on and off by the magnetic force of a coil or a semiconductor switch such as a metal oxide semiconductor field effect transistor (MOSFET). A relay control for a battery used with a vehicle has a function of cutting off the power supply from the battery when a problem occurs in the battery system of the vehicle. The relay control may include one or more relays and pre-charge relays at the positive terminal and the negative terminal, respectively.

In the pre-charge control, there is a risk of inrush current occurring in the high-voltage capacitor on the input side of the inverter when the battery load is connected. To prevent inrush current when starting a vehicle, the pre-charge relay may be operated before connecting the main relay and the pre-charge resistor may be connected.

The high-voltage interlock is a circuit that uses a small signal to detect whether or not all high-voltage parts of the entire vehicle system are connected and may have a function of forcibly opening a relay when opening one location on the entire loop.

When a lithium-ion battery is charged, lithium ions move from a positive electrode to a negative electrode. During this process, side reactions may occur with an electrolyte, which may cause abnormalities in the battery cells.

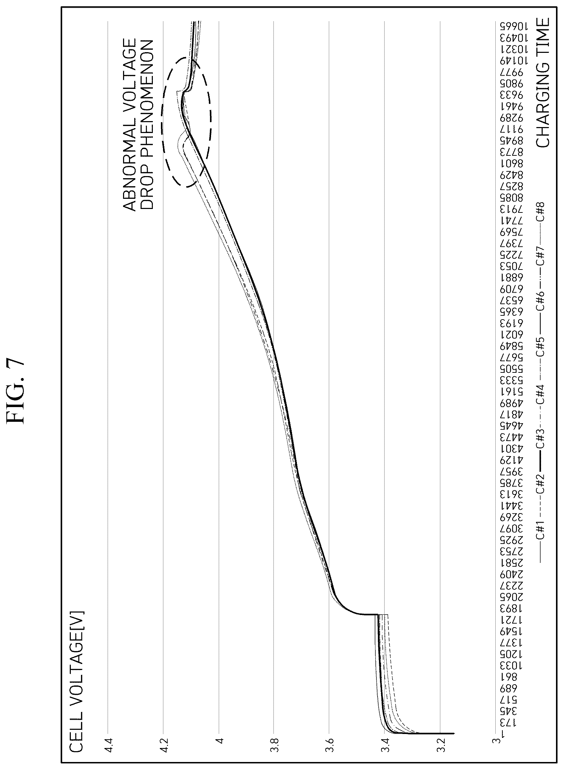

FIG. 7 is a diagram illustrating an abnormal voltage drop phenomenon that occurs due to a side reaction occurring in an upper section of an SOC during battery charging. When this abnormal voltage drop phenomenon is recognized, a side reaction of the battery cell may be detected and cell abnormality may be determined.

According to the present disclosure, the abnormal voltage drop is detected during battery charging in an ESS and electric vehicles, a side reaction is estimated, and it is determined whether a cell is abnormal is determined. Thus, performance degradation can be prepared for and a fire can be prevented. To detect the side reaction, when an amount of a charging voltage drop of each cell exceeds an allowable value and an abnormal voltage drop occurs in an upper section of an SOC when the battery module is charged at a predetermined charging current or more during charging of the battery module, as is shown in FIG. 7, a side reaction is determined to have occurred in a corresponding cell and the cell is identified as an abnormal cell.

The abnormal cell detection algorithm according to the present disclosure may be implemented in a BMS mounted on applications such as an ESS and electric vehicles. But the present disclosure is not limited thereto and the abnormal cell detection algorithm may also be implemented as a separate device.

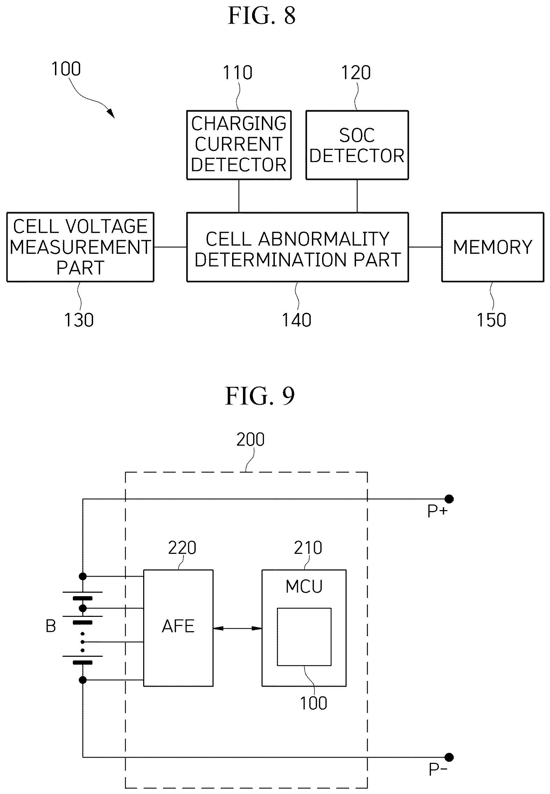

FIG. 8 is a block diagram illustrating an apparatus 100 for detecting an abnormal cell of a battery module by detecting a side reaction according to embodiments of the present disclosure. Each component of the apparatus 100 will be briefly described.

A charging current detector 110 may detect whether a charging current reaches a first criterion for starting an abnormal cell detection operation during charging of a battery module including a plurality of battery cells. An SOC detector 120 may detect whether a SOC reaches a second criterion for starting an abnormal cell detection operation during charging of the battery module. When the charging current detected by the charging current detector 110 reaches the first criterion and the SOC detected by the SOC detector 120 reaches the second criterion, a cell voltage measurement part 130 may measure a voltage of each cell of the battery module.

A cell abnormality determination part 140 may store the measured voltage, which is measured for each cell by the cell voltage measurement part 130, in a memory 150 as a maximum voltage and then measure a current voltage of each cell in real time. When the measured current voltage is greater than the voltage stored in the memory 150, which means a state in which the voltage is increasing without a voltage drop, the current voltage may be stored in the memory 150 as a maximum voltage again to update in real time. During this routine, when the measured current voltage is less than or equal to the maximum voltage stored in the memory 150, the maximum voltage stored in the memory 150 is compared with the measured current voltage. When a difference between the stored maximum voltage and the current voltage is greater than or equal to an allowable value (which corresponds to the abnormal voltage drop of FIG. 7), a side reaction is determined to have occurred in a corresponding cell and the cell may be determined as an abnormal cell.

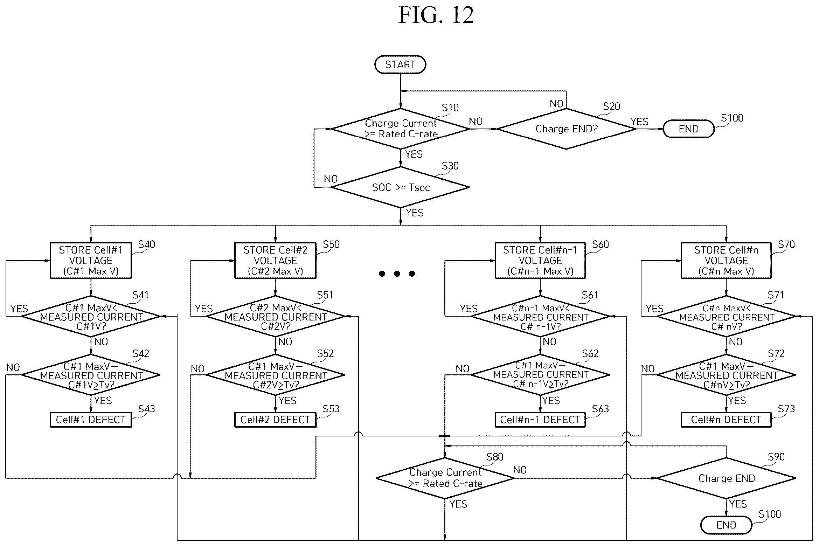

Each component of the apparatus 100 will be described in more detail. To aid understanding, reference will also be made to a process flowchart of a method of detecting an abnormal cell shown in FIG. 12.

As shown in FIG. 7, the apparatus 100 and a method for detecting an abnormal cell of a battery module according to the present disclosure monitors a voltage drop after a significant amount of charging is performed on the battery module to detect an abnormal voltage drop due to a side reaction occurring in an upper section of the SOC. A first criterion for starting an abnormal cell detection operation may be set as, for example, a C-rate rated in the battery module. A second criterion may be set as, for example, about 80% to 90% of the SOC.

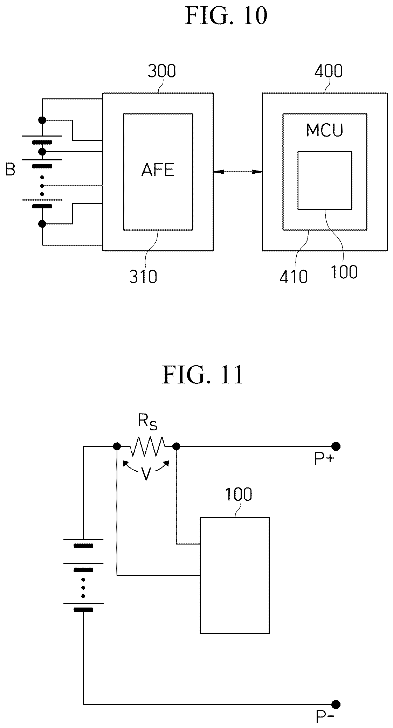

As shown in FIG. 11, the charging current detector 110 for detecting whether the charging current of the battery module reaches the first criterion (i.e., the rated C-rate) may detect whether the charging current reaches the rated C-rate by measuring a voltage v of a shunt resistor Rs included in the battery module or a battery control unit (BCU) and calculating a current flowing in the shunt resistor Rs from the measured voltage v thereof.

The SOC detector 120 for detecting whether the SOC of the battery module reaches the second criterion (i.e., about 80% to about 90% of the SOC) may detect the SOC using one of a compensated end of discharge voltage (CEDV) algorithm and an extended Kalman filter (EKF) algorithm. The CEDV algorithm is basically a type of current integration method that estimates the charge amount (i.e., SOC, state of charge) by integrating over time the current flowing during battery charging/discharging. For example, SOC can be estimated by checking the cell voltage at specific SOC sections during charging/discharging. CEDV algorithm according to this example is herein explained. In this explanation, the cell operating voltage is assumed to be 3.0 V to 4.1 V. First, it is checked whether the cell voltage reaches 3.0 V at 0.1% of SOC during discharge, and if it reaches 3.0 V, SOC is maintain at 0%, and if it does not reach 3.0 V, SOC is maintained at 0.1%. If the cell voltage reaches 3.0 V when SOC is e.g., 3% during discharge, SOC is changed to 0%. On the other hand, during charging, SOC is checked if the cell voltage reaches 4.1 V at 99.9% of SOC. If it reaches the 4.1 V, SOC is maintained at 100%; If it does not, SOC is maintained at 99.9%. If the cell voltage reaches 4.1 V when SOC is e.g., 95% during charging, SOC is changed to 100%. The EKF algorithm is a technique for estimating SOC using the Kalman Filter, a type of Bayes Filter, based on the Equivalent Circuit Model (ECM). The ECM simulates the electrochemical reaction to the battery's input current using an RC circuit. According to the EKF algorithm, the OCV (Open Circuit Voltage) is used as the input and the voltage after passing through R (resistor) and C (capacitor) elements of the RC circuit is used as the output to perform current integration. The result of the current integration allows for real-time monitoring of the cell voltage, thereby enabling the detection of SOC. It will be understood that alternative methods for determining the SOC may performed by the SOC detector 120. For example, the SOC may be estimated by coulomb counting, in which the battery current is measured and integrated over time. As another example, the SOC may be estimated by reading the battery voltage and comparing the voltage to a known discharge curve (i.e. voltage vs SOC).

Whether the charging current detected by the charging current detector 110 reaches the rated C-rate is determined (S10 of FIG. 12), and when the charging current does not reach the rated C-rate, the charging current is continuously monitored until a charging cycle ends (charge END) and the charging current reaches the rated C-rate. When the charging ends (S20), the abnormal cell detection operation ends (S100). When the charging current reaches the rated C-rate, the SOC detector 120 detects whether the detected SOC reaches a second criterion Tsoc (e.g., about 80% to 90%) (S30).

When SOC≥Tsoc in operation S30, the cell voltage measurement part 130 may measure voltages C#1V, C#2V, ..., C#(n-1)V, and C#nV of the cells of the battery module. The cell voltage measurement part 130 may receive the voltage of each cell from the AFE (analog front end) of the BMS.

FIG. 9 shows some embodiments of the BMS 200 including the AFE 220. The BMS 200 includes a micro-control unit (MCU) 210 and an analog front end (AFE) 220. And the apparatus 100 for detecting an abnormal cell of a battery module of the present disclosure may be implemented in the MCU 210. The AFE 220 may be implemented as a semiconductor device that detects a voltage of each cell of a battery module B.

FIG. 10 shows an embodiment in which the BMS is formed separately as a module BMS 300 and a rack BMS 400. An AFE 310 is included in the module BMS 300 located in the battery module B. The apparatus 100 for detecting an abnormal cell of a battery module of the present disclosure may be implemented in an MCU 410 of the rack BMS 400.

The operation of the cell voltage measurement part 130 will be described with reference to FIG. 12.

The cell voltage measurement part 130 measures the voltage of each cell of the battery module and stores the voltage in the memory 150 (S40, S50, S60, and S70). The voltages measured at a current time point may be stored in the memory 150 as maximum voltages of the cells C#1 MaxV, C#2 MaxV, ..., C#n-1 MaxV, and C#n MaxV. Subsequently, the cell voltage measurement part 130 may measure the current voltages C#1V, C#2V, ..., C#(n-1)V, and C#nV of the cells and compare the measured current voltages with the maximum voltages stored in the memory 150 (S41, S51, S61, and S71). When C#1 MaxV<C#1V, C#2 MaxV<C#2V, ..., C#n-1 MaxV<C#(n-1)V, and C#n MaxV<C#nV in the cells, the state is such that the charging voltage of each cell is rising normally and not abnormally decreasing. In this case, the maximum voltage in the memory 150 may be updated with the measured current voltage in real time.

In operations S41, S51, S61, and S71, when C#1 MaxV≥C#1V, C#2 MaxV≥C#2V, ..., C#n-1 MaxV≥C#(n-1)V, and C#n MaxV≥C#nV in the cells, the state is such that the charging voltage of each cell is decreasing abnormally. In this case, the maximum voltage stored in the memory 150 may be compared with the measured current voltage to determine whether the voltage drop is within an allowable range (S42, S52, S62, and S72). For examples, when a difference between the stored maximum voltage and the current voltage ([C#1 MaxV-C#1V], [C#2 MaxV-C#2V], ..., [C#n-1 MaxV-C#(n-1)V], and [C#n MaxV-C#nV]) exceeds an allowable criterion (for example, about 10 mV), it is determined that, since the voltage drop of a corresponding cell cannot be allowable, the corresponding cell is an abnormal cell in which a side reaction has occurred (S43, S53, S63, and S73). A warning may be issued and/or predetermined protective measures may be implemented for cells that are determined to be abnormal.

When the difference between the stored maximum voltage and the current voltage ([C#1 MaxV-C#1V], [C#2 MaxV-C#2V], ..., [C#n-1 MaxV-C#(n-1)V], and [C#n MaxV-C#nV]) is less than a voltage of about 10 mV, the voltage drop of the corresponding cell may be tolerated. In addition, whether the charging current is still greater than or equal to the rated C-rate (i.e., whether it is in a charging state) is determined (S80). If it is determined that the charge current is not greater than or equal to the C-rate, a determination may be made whether the charging ends (S90). If the charging has ended and the abnormal cell detection of the present disclosure is terminated (S100). If the charging has not ended, the routine returns to operation S80 to determine whether the charging current is still greater than or equal to the rated C-rate. If it is determined in S80 that the charge current is greater than or equal to the C-rate, the abnormal cell detection routine returns to the operation of measuring the current voltages C#1V, C#2V, ..., C#(n-1)V, and C#nV of the cells and comparing the measured current voltages with the maximum voltages stored in the memory 150 (S41, S51, S61, and S71) as described above. When the battery is being charged, the abnormal cell detection routine is repeatedly executed until the charging ends (S90).

According to the present disclosure, an abnormal voltage drop during charging of a battery mounted in a battery pack, an energy storage system, an electric vehicle, etc. can be easily recognized by a specific algorithm, a side reaction can be detected, and an abnormal cell can be determined from specific algorithm. Thus performance degradation can be prepared for and a fire can be prevented.

Although the present disclosure has been described above with respect to embodiments thereof, the present disclosure is not limited thereto. Various modifications and variations can be made thereto by those skilled in the art within the scope of the present disclosure.

## Claims

1. An apparatus for detecting an abnormal cell of a battery module, the apparatus comprising:
a charging current detector configured to detect whether a charging current reaches a first criterion during charging of a battery module comprising a plurality of battery cells;
a state of charge detector configured to detect whether a state of charge (SOC) of the battery module reaches a second criterion;
a cell voltage measurement part configured to measure a voltage of each of the battery cells when the charging current reaches the first criterion and the SOC reaches the second criterion; and
a cell abnormality determination part configured to (i) store the measured voltage of each of the battery cells as a maximum voltage, (ii) compare a current voltage with the stored maximum voltage when the current voltage is less than or equal to the maximum voltage, and, (iii) determine that a corresponding battery cell of the battery cells is an abnormal cell when a difference between the stored maximum voltage and the current voltage is greater than or equal to an allowable value.

2. The apparatus as claimed in claim 1, wherein the first criterion is a rated C-rate of the battery module.

3. The apparatus as claimed in claim 1 or claim 2, wherein the charging current detector is configured to measure a voltage of a shunt resistor included in the battery module, calculate a current flowing in the shunt resistor from the measured voltage thereof, and detect the charging current.

4. The apparatus as claimed in any preceding claim, wherein the second criterion is 80% to 90% of the state of charge.

5. The apparatus as claimed in any preceding claim, wherein the state of charge detector is configured to detect the state of charge using one of a compensated end of discharge voltage algorithm and an extended Kalman filter algorithm.

6. The apparatus as claimed in any preceding claim, wherein the cell voltage measurement part is configured to receive the voltage of each of the battery cells from an analog front end of a battery management system.

7. The apparatus as claimed in any preceding claim, wherein the allowable value is 10 mV.

8. A method of detecting an abnormal cell of a battery module, the method comprising:
detecting whether a charging current reaches a first criterion during charging of a battery module comprising a plurality of battery cells;
detecting whether a state of charge of the battery module reaches a second criterion;
measuring a voltage of each of the battery cells when a charging current reaches the first criterion and the state of charge reaches the second criterion; and
a cell abnormality determination operation of (i) storing the measured voltage of each of the battery cells as a maximum voltage, (ii) comparing a current voltage with the stored maximum voltage when the current voltage that is less than or equal to the maximum voltage is measured, and (iii) determining that a corresponding battery cell of the battery cells is an abnormal cell when a difference between the stored maximum voltage and the current voltage is greater than or equal to an allowable value.

9. The method as claimed in claim 8, wherein the first criterion is a rated C-rate of the battery module.

10. The method as claimed in claim 8 or claim 9, wherein the detecting of whether the charging current reaches the first criterion comprises measuring a voltage of a shunt resistor included in the battery module, calculating a current flowing in the shunt resistor from the measured voltage thereof, and detecting the charging current.

11. The method as claimed in any one of claims 8 - 10, wherein the second criterion ris 80% to 90% of the state of charge.

12. The method as claimed in any one of claims 8 - 11, wherein the detecting whether the state of charge of the battery module reaches the second criterion comprises detecting the state of charge using one of a compensated end of discharge voltage algorithm and an extended Kalman filter algorithm.

13. The method as claimed in any one of claims 8 - 12, wherein the voltage of each of the battery cells is received from an analog front end of a battery management system.

14. The method as claimed in any one of claims 8 - 13, wherein the allowable value is 10 mV.
